# EUROPEAN PATENT APPLICATION

(11) **EP 4 718 697 A1**
(43) Date of publication of application: **01.04.2026**
(21) Application number: 24924269.4
(22) Date of filing: 22.08.2024
(51) Int. Cl.: H02M 1/08, H02M 1/32

(54) **POWER CIRCUIT AND CONTROL METHOD APPLICABLE THERETO**

(30) Priority: 09.08.2024 CN 202411094368
(71) Applicant: Delta Electronics, Inc., Taoyuan City 33370 (TW)
(72) Inventor: WEN, Tsung-Hsiu, Taoyuan City 32063 (TW); CHEN, Hong-Wei, Taoyuan City 32063 (TW); LI, Jia-Yu, Taoyuan City 32063 (TW)
(74) Representative: Uexküll & Stolberg
(86) International application number: PCT/CN2024/113959
(87) International publication number: WO 2026/031278

(57) **Abstract**

A power circuit and a control method thereof are disclosed. The power circuit includes a switching element, a switch driver chip, a clamping circuit and a capacitor. The switch element includes a control terminal, a first current conduction terminal and a second current conduction terminal. The switch driver chip includes a desaturation detection circuit and a switch driving circuit. The desaturation detection circuit includes a comparator. A non-inverting input terminal of the comparator is electrically connected to a current source and the first current conduction terminal. An inverting input terminal of the comparator receives a reference voltage. The switch driving circuit outputs a first control signal to control the operations of the switching element according to a comparator output signal from the output terminal of the comparator. A voltage at the non-inverting input terminal is clamped by the clamping circuit when the switching element is turned on. The capacitor is electrically connected between the non-inverting input terminal and a ground terminal. A voltage value of the reference voltage is regulated according to a capacitance value of the capacitor and a switching specification of the switching element. If the capacitor voltage of the capacitor is greater than the reference voltage, the switching element is turned off under control of the switch driving circuit.

## Description

### FIELD OF THE INVENTION

The present disclosure relates to the field of a power circuit technology, and more particularly to a power circuit capable of optimizing the protection of switching elements and a method for controlling the power circuit.

### BACKGROUND OF THE INVENTION

Generally, a power circuit for an electric vehicle (EV) driver is usually equipped with at least one switching element. The switching element is an insulated gate bipolar transistor (IGBT), a silicon carbide power device (SiC-MOSFET), a silicon power device (Si-MOSFET), a gallium nitride power device (GaN FET), or any other appropriate power semiconductor device. By controlling the operation of the switching element, the purpose of switching a voltage and/or a current can be achieved.

However, different switching elements have different switching specifications and characteristics. For example, in case that the switching element is implemented with an insulated gate bipolar transistor (IGBT) or a silicon carbide power device, the current protection response times of the insulated gate bipolar transistor and the silicon carbide power device are significantly distinguished. For example, the insulated gate bipolar transistor typically has a current protection response time of approximately 10 µs, whereas the silicon carbide power device has a current protection response time of about 2 µs. As a result, the same protection circuit cannot simultaneously meet the requirements of both components. For example, if the protection circuit designed for a silicon carbide power device is applied to protect an insulated gate bipolar transistor, the slower current protection response time of the insulated gate bipolar transistor may cause the protection circuit to be more susceptible to interference. Consequently, the risk of erroneously triggering the protection circuit increases, and the applications of the conventional power circuits are usually not satisfied.

In order to overcome the drawbacks of the conventional technologies, it is important to provide a power circuit and a control method for protecting switching elements with different switching specifications and characteristics.

### SUMMARY OF THE INVENTION

The present disclosure provides a power circuit and a control method thereof. The power circuit can meet the current protection response times of the switching elements with different switching specifications and characteristics to perform the protection. Consequently, the application of the power circuit is expended.

In accordance with an aspect of the present disclosure, a power circuit is provided. The power circuit includes at least one switching element, a switch driver chip, a clamping circuit and a capacitor. Each of the at least one switching element includes a control terminal, a first current conduction terminal and a second current conduction terminal. The at least one switching element includes a first switching element. The switch driver chip is configured to control operations of the at least one switching element. The switch driver chip includes a desaturation detection circuit and a first switch driving circuit. The desaturation detection circuit includes a comparator. A non-inverting input terminal of the comparator is electrically connected to a first current source and the first current conduction terminal of each of the at least one switching element. An inverting input terminal of the comparator is electrically connected to an adjustable voltage source to receive a reference voltage from the adjustable voltage source. The first switch driving circuit is electrically connected to an output terminal of the comparator and the control terminal of the first switching element. The first switch driving circuit outputs a first control signal to the control terminal of the first switching element to control the operations of the first switching element according to a comparator output signal from the output terminal of the comparator. The clamping circuit is electrically connected between the non-inverting input terminal of the comparator and the first current conduction terminal of each of the at least one switching element. When one of the at least one switching element is turned on, a voltage at the non-inverting input terminal of the comparator is clamped. The capacitor is electrically connected between the non-inverting input terminal of the comparator and a ground terminal. The capacitor has a capacitor voltage. A voltage value of the reference voltage is regulated according to a capacitance value of the capacitor and a switching specification of the at least one switching element. When the capacitor voltage of the capacitor is greater than the reference voltage, the first switching element is turned off under control of the first switch driving circuit.

In accordance with another aspect of the present disclosure, a control method for a power circuit is provided. The power circuit includes at least one switching element, a switch driver chip, a clamping circuit and a capacitor. Each of the at least one switching element includes a control terminal, a first current conduction terminal and a second current conduction terminal. The at least one switching element includes a first switching element. The switch driver chip is configured to control operations of the at least one switching element. The switch driver chip includes a desaturation detection circuit and a first switch driving circuit. The desaturation detection circuit includes a comparator. A non-inverting input terminal of the comparator is electrically connected to a first current source and the first current conduction terminal of each of the at least one switching element. An inverting input terminal of the comparator is electrically connected to an adjustable voltage source to receive a reference voltage from the adjustable voltage source. The first switch driving circuit is electrically connected to an output terminal of the comparator and the control terminal of the first switching element. The first switch driving circuit outputs a first control signal to the control terminal of the first switching element to control the operations of the first switching element according to a comparator output signal from the output terminal of the comparator. The clamping circuit is electrically connected between the non-inverting input terminal of the comparator and the first current conduction terminal of each of the at least one switching element. A voltage at the non-inverting input terminal of the comparator is clamped when one of the at least one switching element is turned on. The capacitor is electrically connected between the non-inverting input terminal of the comparator and a ground terminal. The capacitor has a capacitor voltage. The control method includes the following steps. In a step (S1), a voltage value of the reference voltage is regulated according to a capacitance value of the capacitor and a switching specification of the first switching element. In a step (S2), when the capacitor voltage is greater than the reference voltage, the first switch driving circuit outputs the first control signal according to the comparator output signal, and the first switching element is turned off according to the first control signal.

### BRIEF DESCRIPTION OF THE DRAWINGS

FIG. 1 is a schematic circuit diagram illustrating the circuitry topology of a power circuit according to a first embodiment of the present disclosure;
FIG. 2 is a schematic circuit diagram illustrating the circuitry topology of a power circuit according to a second embodiment of the present disclosure;
FIG. 3 is a schematic circuit diagram illustrating the circuitry topology of a power circuit according to a third embodiment of the present disclosure;
FIGS. 4A, 4B, 4C and 4D are waveform diagrams illustrating the first control signal received by the control terminal of the first switching element and the second control signal received by the control terminal of the second switching element when the power circuit shown in FIG. 3 is operated in different modes, respectively;
FIG. 5 is a flowchart of a control method for a power circuit shown in FIG. 1; and
FIG. 6 is a flowchart of a control method for the power circuit shown in FIG. 3.

### Description of reference numerals:

1, 1a : power circuit
3 : switch driving chip
4 : clamping circuit
Cblk : capacitor
2a : first switching element
T1, T4 : control terminal
T2, T5 : first current conduction terminal
T3, T6 : second current conduction terminal
G : ground terminal
30 : desaturation detection circuit
CP : comparator
CS1 : first current source
Uref : adjustable voltage source
VDD : voltage source
31a : first switch driving circuit
Vd : comparator output signal
R1 : first resistor
D1 : first diode
5, 5a : control circuit
Fault : first input terminal
Fault_out : first output terminal
Gate_IN : second input terminal
PWM_IN : second output terminal
310, 312 : logic circuit
311, 313 : switch switching circuit
Q1, Q3 : first switch
Q2, Q4 : second switch
CS2 : second current source
R2 : second resistor
D2 : second diode
Z : zener diode
2b : second switching element
31b : second switch driving circuit
Gate_IN1 : third input terminal
PWM_IN1 : third output terminal
CS3 : third current source
VDD1 : first voltage source
VDD2 : second voltage source
S1~S2, S10~S20 : steps of the control method

### DETAILED DESCRIPTION OF THE PREFERRED EMBODIMENT

The present disclosure will now be described more specifically with reference to the following embodiments. It is to be noted that the following descriptions of preferred embodiments of this disclosure are presented herein for purpose of illustration and description only. It is not intended to be exhaustive or to be limited to the precise form disclosed.

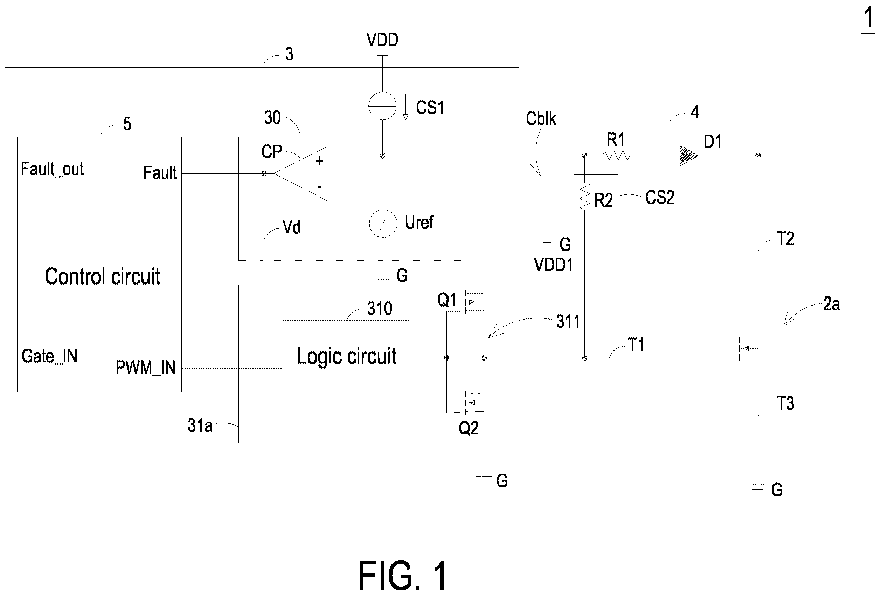

FIG. 1 is a schematic circuit diagram illustrating the circuitry topology of a power circuit according to a first embodiment of the present disclosure. In the embodiment, the power circuit 1 can be applied to an electric vehicle driver. The power circuit 1 includes at least one switching element, a switch driver chip 3, a clamping circuit 4 and a capacitor Cblk. As shown in FIG. 1, the at least one switching element includes a first switching element 2a. Preferably but not exclusively, the first switching element 2a is an insulated gate bipolar transistor (IGBT), a silicon carbide power device (SiC-MOSFET), a silicon power device (Si-MOSFET), a gallium nitride power device (GaN FET), and/or any other appropriate power semiconductor device. The first switching element 2a includes a control terminal T1, a first current conduction terminal T2 and a second current conduction terminal T3.

The switch driver chip 3 is electrically connected to the control terminal T1 of each switching element. For example, the switch driver chip 3 is electrically connected to the control terminal T1 of the first switching element 2a for controlling the operations of the first switching element 2a. In an embodiment, the switch driver chip 3 includes a desaturation detection circuit 30 and at least one switch driving circuit. The desaturation detection circuit 30 is electrically connected to the first current conduction terminal T2 of the first switching element 2a and each switch driving circuit. The desaturation detection circuit 30 is configured to provide a comparator output signal Vd to each switch driving circuit. The desaturation detection circuit 30 includes a comparator CP. The non-inverting input terminal of the comparator CP is electrically connected to a first current source CS1 and the first current conduction terminal T2 of the first switching element 2a. The inverting input terminal of the comparator CP is electrically connected to an adjustable voltage source Uref. In addition, the inverting input terminal of the comparator CP receives a reference voltage from the adjustable voltage source Uref. The voltage value of the reference voltage is regulated according to the capacitance value of the capacitor Cblk and the switching specification of the first switching element 2a. In some embodiments, the first current source CS1 is further electrically connected to a voltage source VDD.

As shown in FIG. 1, the at least one switch driving circuit includes a first switch driving circuit 31a. The first switch driving circuit 31a is electrically connected to the output terminal of the comparator CP and the control terminal T1 of the first switching element 2a. The first switch driving circuit 31a is configured to output a first control signal to the control terminal T1 to control the operations of the first switching element 2a. Furthermore, the voltage level of the first control signal is regulated according to the voltage level state (e.g., a high-level state or a low-level state) of the comparator output signal Vd outputted from the output terminal of the comparator CP.

The first terminal of the clamping circuit 4 is electrically connected to the non-inverting input terminal of the comparator CP. The second terminal of the clamping circuit 4 is electrically connected to the first current conduction terminal T2 of the first switching element 2a. The clamping circuit 4 is configured to clamp the voltage at the non-inverting input terminal of the comparator CP when the first switching element 2a is turned on. The first terminal of the capacitor Cblk is electrically connected to the non-inverting input terminal of the comparator CP and the first terminal of the clamping circuit 4. The second terminal of the capacitor Cblk is electrically connected to a ground terminal G. In addition, the capacitor Cblk has a capacitor voltage.

When the first switching element 2a is abnormal and short-circuited, the capacitor voltage of the capacitor Cblk will increase. The increase of the capacitor voltage of the capacitor Cblk will be reflected at the non-inverting input terminal of the comparator CP. Consequently, the voltage of the non-inverting input terminal of the comparator CP is greater than the reference voltage provided by the adjustable voltage source Uref. Consequently, the comparator output signal Vd is in the high-level state. Meanwhile, the first switch driving circuit 31a outputs the first control signal to the control terminal T1 of the first switching element 2a to control the first switching element 2a to be in the non-conducting state. As a result, the purpose of protecting the first switching element 2a is achieved.

In an embodiment, the voltage value of the reference voltage provided by the adjustable voltage source Uref is freely set according to the capacitance value of the capacitor Cblk and the switching specification of the first switching element 2a. In case that the first switching element 2a is an IGBT switch, the reference voltage of the adjustable voltage source Uref is regulated to have a larger voltage value. Consequently, the current protection response time of the first switching element 2a is regulated to be within 10µs. In case that the first switching element 2a is a silicon carbide switch, the reference voltage of the adjustable voltage source Uref is regulated to have a smaller voltage value. Consequently, the current protection response time of the first switching element 2a is regulated to be within 2µs. In other words, regardless of the switching specification of the first switching element 2a, the power circuit 1 of the present disclosure can meet the current protection response time of the first switching element 2a. As a result, the applications of the power circuit 1 will be expanded.

In an embodiment, the reference voltage of the adjustable voltage source Uref is generated by an internal circuit of the switch driver chip 3, or the reference voltage of the adjustable voltage source Uref is a variable external voltage received by a pin of the switch driver chip 3. The clamping circuit 4 includes a first resistor R1 and a first diode D1. The first terminal of the first resistor R1 is electrically connected to the non-inverting input terminal of the comparator CP. The second terminal of the first resistor R1 is electrically connected to the anode of the first diode D1. The cathode of the first diode D1 is electrically connected to the first current conduction terminal T2 of the first switching element 2a. In an embodiment, the capacitance value of the capacitor Cblk is 1000pF, which is effective to enhance the anti-interference ability of the power circuit 1. It is noted that the capacitance value of the capacitor Cblk is not restricted. The capacitance value of the capacitor Cblk is regulated according to the characteristics of the first switching element 2a. The increase of the capacitance value of the capacitor Cblk can increase the anti-interference tolerance while meeting the protection time requirements.

In some embodiments, the power circuit 1 further includes a control circuit 5. A first input terminal Fault of the control circuit 5 is electrically connected to the output terminal of the comparator CP and receives the comparator output signal Vd. A first output terminal Fault_out of the control circuit 5 outputs a warning signal according to the comparator output signal Vd received by the first input terminal. A second input terminal Gate_IN of the control circuit 5 is electrically connected to a micro control unit (not shown) to receive a control signal from the micro control unit. The control circuit 5 performs a logic control operation with reference to the second input terminal Gate_IN. A second output terminal PWM_IN of the control circuit 5 is electrically connected to the first switch driving circuit 31a to provide a pulse width modulation (PWM) signal according to the logic control result of the control circuit 5 at the second input terminal Gate_IN. The PWM signal is provided to the control terminal T1 of the first switching element 2a to control the operations of the first switching element 2a.

In an embodiment, the first switch driving circuit 31a includes a logic circuit 310 and a switch switching circuit 311. The first input terminal of the logic circuit 310 is electrically connected to the output terminal of the comparator CP to receive the comparator output signal Vd. The second input terminal of the logic circuit 310 is electrically connected to the second output terminal PWM_IN of the control circuit 5 to receive the PWM signal. The output terminal of logic circuit 310 outputs a first switching signal to the switch switching circuit 311 according to the PWM signal and the comparator output signal Vd. The switch switching circuit 311 includes a first switch Q1 and a second switch Q2. The control terminal of the first switch Q1 is electrically connected to the output terminal of the logic circuit 310. The first current conduction terminal of the first switch Q1 is electrically connected to a first voltage source VDD1. The first voltage source VDD1 is further connected to the voltage source VDD. The control terminal of the second switch Q2 is electrically connected to the output terminal of the logic circuit 310. The first current conduction terminal of the second switch Q2 is electrically connected to the second current conduction terminal of the first switch Q1 and the control terminal T1 of the first switching element 2a. The first switch driving circuit 31a outputs the first control signal to the first switching element 2a through the first current conduction terminal of the second switch Q2 and the second current conduction terminal of the first switch Q1. The second current conduction terminal of the second switch Q2 is electrically connected to the ground terminal G. When the first switching element 2a is abnormal and short-circuited, the comparator output signal Vd is in the high-level state. Meanwhile, the logic circuit 310 outputs the first switching signal. According to the first switching signal, the first switch Q1 is turned off, and the second switch Q2 is turned on. Consequently, the first switching element 2a is turned off, and the purpose of protecting the first switching element 2a is achieved.

In some embodiments, the power circuit 1 further includes a second current source CS2. The second current source CS2 is electrically connected between the second current conduction terminal of the first switch Q1 of the first switch driving circuit 31a and the first terminal of the capacitor Cblk. In an embodiment, the second current source CS2 includes a second resistor R2. The second current source CS2 is configured to generate an additional charging current to charge the capacitor Cblk. Since the capacitance value of the capacitor Cblk is increased, the current protection response time of the first switching element 2a can meet the requirements.

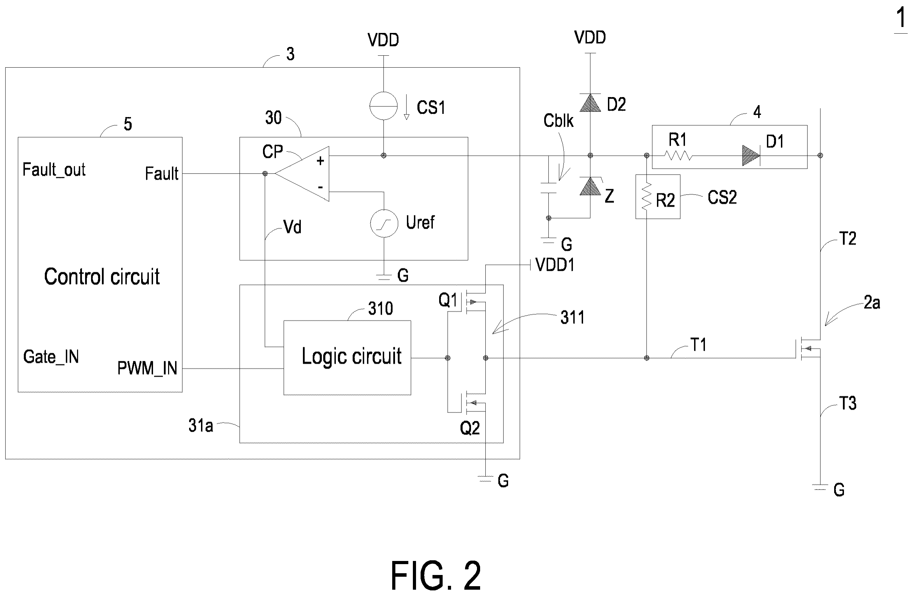

FIG. 2 is a schematic circuit diagram illustrating the circuitry topology of a power circuit according to a second embodiment of the present disclosure. As shown in FIG. 2, the power circuit 1 further includes a first voltage protection circuit. The first voltage protection circuit includes a second diode D2. The cathode of the second diode D2 is electrically connected to the voltage source VDD. The anode of the second diode D2 is electrically connected between the first terminal of the clamping circuit 4 and the non-inverting input terminal of the comparator CP. When an abnormal sudden transient high voltage such as electrostatic discharge (ESD) occurs, the first voltage protection circuit can provide a conduction path to protect the downstream circuitry. Furthermore, when the abnormal sudden transient high voltage occurs and the voltage at the anode of the second diode D2 is greater than the voltage of the voltage source VDD, the second diode D2 is turned on. Consequently, the transient energy flows into the wiring line of the voltage source VDD, and the capacitor in its path absorbs the transient energy. In this way, the overvoltage protection function is achieved.

In an embodiment, the power circuit 1 further includes a second voltage protection circuit. The second voltage protection circuit includes a Zener diode Z. The cathode of the Zener diode Z is electrically connected between the first terminal of the clamping circuit 4 and the non-inverting input terminal of the comparator CP. The anode of the Zener diode Z is electrically connected to the ground terminal G. The second voltage protection circuit can provide a conduction path when the abnormal sudden transient high voltage occurs. For example, when the abnormal sudden transient high voltage occurs and the voltage at the cathode of the Zener diode Z is greater than the breakdown voltage of the Zener diode Z, the Zener diode Z is turned on. Consequently, the transient energy flows through the Zener diode Z to the ground terminal G instead of flowing into the switch driver chip 3. By changing the noise path, the overvoltage protection function is achieved. The power circuit 1 may include one of the first voltage protection circuit and the second voltage protection circuit, or both of them.

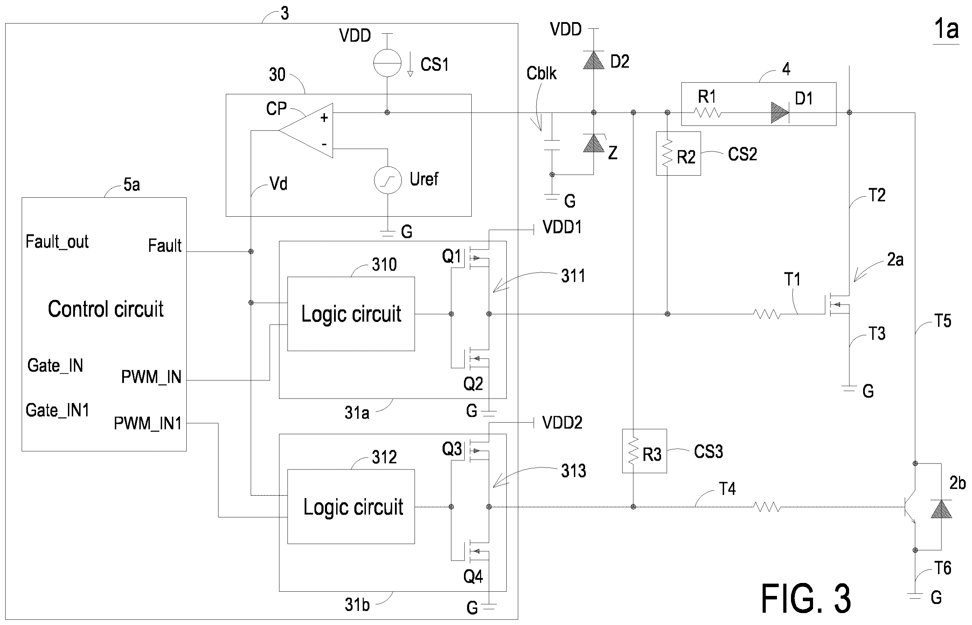

FIG. 3 is a schematic circuit diagram illustrating the circuitry topology of a power circuit according to a third embodiment of the present disclosure. The circuitry topology of the power circuit 1a of this embodiment is similar to that of the power circuit 1 shown in FIG. 2. Component parts and elements corresponding to those of the embodiment shown in FIG. 2 are designated by identical numeral references, and detailed descriptions thereof are omitted. In this embodiment, the power circuit 1a further includes a second switching element 2b in addition to including the first switching element 2a. The second switching element 2b includes a control terminal T4, a first current conduction terminal T5 and a second current conduction terminal T6. In some embodiments, the second switching element 2b is an insulated gate bipolar transistor, a silicon carbide power device, a silicon power device, a gallium nitride power device, and/or any other appropriate power semiconductor device. Preferably, the first switching element 2a and the second switching element 2b are different types of power semiconductor devices. For example, the first switching element 2a is a silicon carbide power device, and the second switching element 2b is an insulated gate bipolar transistor.

In addition, the switch driver chip 3 further includes a second switch driving circuit 31b in addition to the first switch driving circuit 31a. The second switch driving circuit 31b is electrically connected to the output terminal of the comparator CP and the control terminal T4 of the second switching element 2b. The second switch driving circuit 31b is configured to output a second control signal to the control terminal T4 to control the operation of the second switching element 2b. Furthermore, the voltage level of the second control signal is regulated according to the voltage level state (e.g., a high-level state or a low-level state) of the comparator output signal Vd outputted from the output terminal of the comparator CP.

In addition, the control circuit 5a further includes a third input terminal Gate_IN1 and a third output terminal PWM_IN1. The third input terminal Gate_IN1 is electrically connected to the micro control unit to receive the control signal from the micro control unit. The control circuit 5a performs a logic control operation with reference to the third input terminal Gate_IN1. The third output terminal PWM_IN1 is electrically connected to the second switch driving circuit 31b to provide another pulse width modulation (PWM) signal according to the logic control result of the control circuit 5a at the third input terminal Gate_IN1 to control the control terminal T4 of the second switching element 2b.

In an embodiment, the second switch driving circuit 31b includes a logic circuit 312 and a switch switching circuit 313. The first input terminal of the logic circuit 312 is electrically connected to the output terminal of the comparator CP to receive the comparator output signal Vd. The second input terminal of the logic circuit 312 is electrically connected to the third output terminal PWM_IN1 of the control circuit 5a to receive the pulse width modulation signal. The logic circuit 310 outputs a second switching signal to the switch switching circuit 313 at the output terminal of the logic circuit 310 according to the PWM signal from the third output terminal PWM_IN1 and the comparator output signal Vd. The switch switching circuit 313 includes a first switch Q3 and a second switch Q4. The control terminal of the first switch Q3 is electrically connected to the output terminal of the logic circuit 312. The first current conduction terminal of the first switch Q3 is electrically connected to a second voltage source VDD2. The second voltage source VDD2 is connected to the voltage source VDD. The control terminal of the second switch Q4 is electrically connected to the output terminal of the logic circuit 312. The first current conduction terminal of the second switch Q4 is electrically connected to the second current conduction terminal of the first switch Q3 and the control terminal T1 of the second switching element 2b. The second switch driving circuit 31b outputs the second control signal to the second switching element 2b through the first current conduction terminal of the second switch Q4 and the second current conduction terminal of the first switch Q3. The second current conduction terminal of the second switch Q4 is electrically connected to the ground terminal G. When the second switching element 2b is abnormal and short-circuited, the comparator output signal Vd is in the high-level state. Meanwhile, the logic circuit 312 outputs the second control signal. According to the second control signal, the first switch Q3 is turned off, and the second switch Q4 is turned on. Consequently, the second switching element 2b is turned off, and the purpose of protecting the second switching element 2b is achieved.

The power circuit 1a further includes a third current source CS3. The third current source CS3 is electrically connected between the second current conduction terminal of the first switch Q3 of the second switch driving circuit 31b and the first terminal of the capacitor Cblk. In an embodiment, the third current source CS3 includes a third resistor R3. The third current source CS3 is configured to generate an additional charging current to charge the capacitor Cblk. Since the capacitance value of the capacitor Cblk is increased, the current protection response time of the second switching element 2b can meet the requirements.

In an embodiment, a source voltage from the voltage source VDD is regulated into two different voltages according to the Vgs specifications of the first switching element 2a and the second switching element 2b, and the two different voltages are respectively provided to the first voltage source VDD1 and the second voltage source VDD2. For example, if the Vgs specifications of the first switching element 2a and the second switching element 2b are different, the source voltage from the voltage source VDD is regulated to provide different voltages to the first voltage source VDD1 and the second voltage source VDD2. For example, assuming that the first switching element 2a is an IGBT switch with a Vgs of 15V and the second switching element 2b is a GaN switch with a Vgs of 8V, the VDD voltage is regulated to provide 15V to the first voltage source VDD1 and 8V to the second voltage source VDD2.

In an embodiment, the voltage source VDD, the first voltage source VDD1 and the second voltage source VDD2 may also be different voltage sources disposed on a system board where the power circuit 1 is located. These voltages sources provide the corresponding voltages to the power circuit 1 through peripheral circuits (not shown).

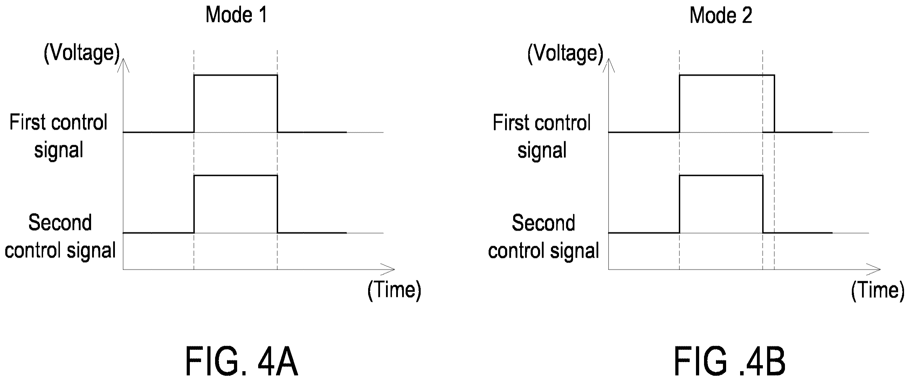

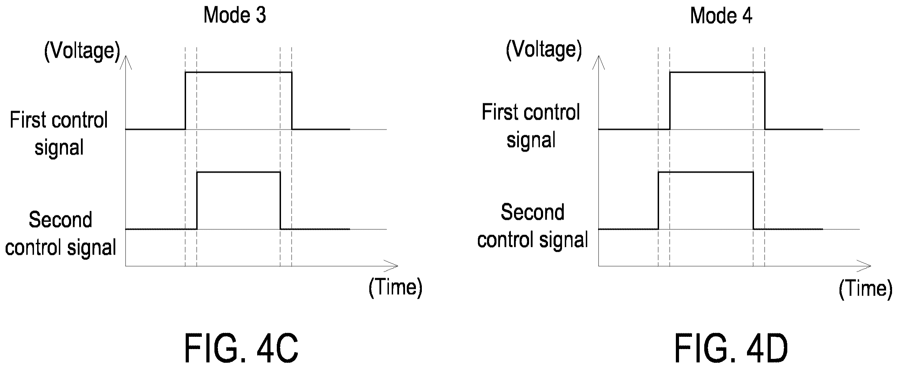

FIGS. 4A, 4B, 4C and 4D are waveform diagrams illustrating the first control signal received by the control terminal of the first switching element and the second control signal received by the control terminal of the second switching element when the power circuit shown in FIG. 3 is operated in different modes, respectively. As shown in FIG. 4A, the first switching element 2a and the second switching element 2b are operated in the first operation mode. In the first operation mode, the first switching element 2a and the second switching element 2b are turned on simultaneously, and the first switching element 2a and the second switching element 2b are turned off simultaneously. When the first switching element 2a and the second switching element 2b start to be turned on, the reference voltage provided by the adjustable voltage source Uref is regulated to a first voltage level, e.g., 14V. The first voltage level (14V) is the voltage corresponding to the current protection response time of the second switching element 2b (e.g., an insulating gate bipolar transistor). When the first switching element 2a and the second switching element 2b are in a fully turn-on state, the reference voltage provided by the adjustable voltage source Uref is regulated to a second voltage level, e.g., 6V. The second voltage level (6V) is the voltage corresponding to the current protection response time of the first switching element 2a (e.g., a silicon carbide switch). When the first switching element 2a and the second switching element 2b start to be turned off from the fully turn-on state, the reference voltage provided by the adjustable voltage source Uref is regulated to the first voltage level.

As shown in FIG. 4B, the first switching element 2a and the second switching element 2b are operated in the second operation mode. In the second operation mode, the first switching element 2a and the second switching element 2b are turned on simultaneously. However, the timing of turning off the first switching element 2a is later than the timing of turning off the second switching element 2b. When the first switching element 2a and the second switching element 2b start to be turned on, the reference voltage provided by the adjustable voltage source Uref is regulated to the first voltage level. When the first switching element 2a and the second switching element 2b are in a fully turn-on state, the reference voltage provided by the adjustable voltage source Uref is regulated to the second voltage level. When the second switching element 2b starts to be turned off from the fully turn-on state, the reference voltage provided by the adjustable voltage source Uref is regulated to the second voltage level.

As shown in FIG. 4C, the first switching element 2a and the second switching element 2b are operated in the third operation mode. In the third operation mode, the timing of turning on the first switching element 2a is earlier than the timing of turning on the second switching element 2b, and the timing of turning off the first switching element 2a is later than the timing of turning off the second switching element 2b. When the first switching element 2a starts to be turned on, the reference voltage provided by the adjustable voltage source Uref is regulated to the second voltage level. When the first switching element 2a and the second switching element 2b are in a fully turn-on state, the reference voltage provided by the adjustable voltage source Uref is regulated to the second voltage level. When the second switching element 2b starts to be turned off from the fully turn-on state, the reference voltage provided by the adjustable voltage source Uref is regulated to the second voltage level.

As shown in FIG. 4D, the first switching element 2a and the second switching element 2b are operated in the fourth operation mode. In the fourth operation mode, the timing of turning on the second switching element 2b is earlier than the timing of turning on the first switching element 2a, and the timing of turning off the first switching element 2a is later than the timing of turning off the second switching element 2b. When the second switching element 2b starts to be turned on, the reference voltage provided by the adjustable voltage source Uref is regulated to the first voltage level. When the first switching element 2a and the second switching element 2b are in a fully turn-on state, the reference voltage provided by the adjustable voltage source Uref is regulated to the second voltage level. When the second switching element 2b starts to be turned off from the fully turn-on state, the reference voltage provided by the adjustable voltage source Uref is regulated to the second voltage level.

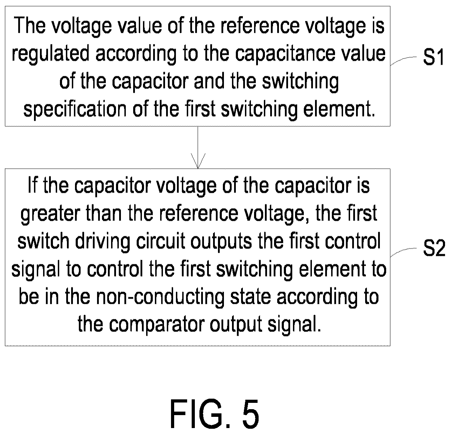

FIG. 5 is a flowchart of a control method for a power circuit shown in FIG. 1. The control circuit can be applied to the power circuit 1 of FIG. 1. The control method includes the following steps.

In a step (S1), the voltage value of the reference voltage is regulated according to the capacitance value of the capacitor Cblk and the switching specification of the first switching element 2a.

In a step (S2), if the capacitor voltage of the capacitor Cblk is greater than the reference voltage, the first switch driving circuit 31a outputs the first control signal to control the first switching element 2a to be in the non-conducting state according to the comparator output signal.

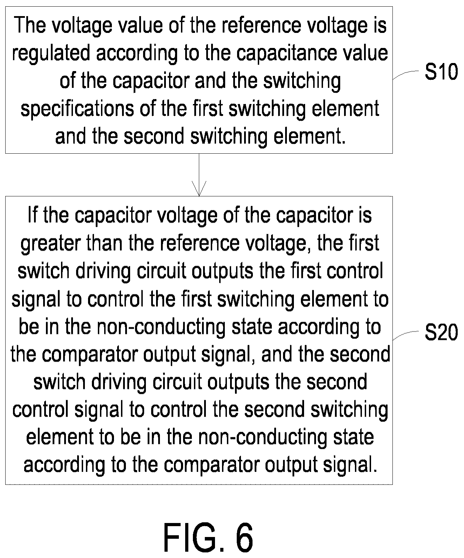

FIG. 6 is a flowchart of a control method for the power circuit shown in FIG. 3. The control circuit can be applied to the power circuit 1a of FIG. 3. The control method includes the following steps.

In a step (S10), the voltage value of the reference voltage is regulated according to the capacitance value of the capacitor Cblk and the switching specifications of the first switching element 2a and the second switching element 2b.

In a step (S20), if the capacitor voltage of the capacitor Cblk is greater than the reference voltage, the first switch driving circuit 31a outputs the first control signal to control the first switching element 2a to be in the non-conducting state according to the comparator output signal, and the second switch driving circuit 31b outputs the second control signal to control the second switching element 2b to be in the non-conducting state according to the comparator output signal.

In a first operation mode, the first switching element 2a and the second switching element 2b are turned on simultaneously, and the first switching element 2a and the second switching element 2b are turned off simultaneously. In the step (S1), the voltage value of the reference voltage is regulated according to the following strategies. When the first switching element 2a and the second switching element 2b start to be turned on, the reference voltage provided by the adjustable voltage source Uref is regulated to a first voltage level. When the first switching element 2a and the second switching element 2b are in a fully turn-on state, the reference voltage provided by the adjustable voltage source Uref is regulated to the second voltage level. When the first switching element 2a and the second switching element 2b start to be turned off from the fully turn-on state, the reference voltage provided by the adjustable voltage source Uref is regulated to the first voltage level.

In the second operation mode, the first switching element 2a and the second switching element 2b are turned on simultaneously. However, the timing of turning off the first switching element 2a is later than the timing of turning off the second switching element 2b. In the step (S1), the voltage value of the reference voltage is regulated according to the following strategies. When the first switching element 2a and the second switching element 2b start to be turned on, the reference voltage provided by the adjustable voltage source Uref is regulated to the first voltage level. When the first switching element 2a and the second switching element 2b are in a fully turn-on state, the reference voltage provided by the adjustable voltage source Uref is regulated to the second voltage level. When the second switching element 2b starts to be turned off from the fully turn-on state, the reference voltage provided by the adjustable voltage source Uref is regulated to the second voltage level.

In the third operation mode, the timing of turning on the first switching element 2a is earlier than the timing of turning on the second switching element 2b, and the timing of turning off the first switching element 2a is later than the timing of turning off the second switching element 2b. In the step (S1), the voltage value of the reference voltage is regulated according to the following strategies. When the first switching element 2a starts to be turned on, the reference voltage provided by the adjustable voltage source Uref is regulated to the second voltage level. When the first switching element 2a and the second switching element 2b are in a fully turn-on state, the reference voltage provided by the adjustable voltage source Uref is regulated to the second voltage level. When the second switching element 2b starts to be turned off from the fully turn-on state, the reference voltage provided by the adjustable voltage source Uref is regulated to the second voltage level.

In the fourth operation mode, the timing of turning on the second switching element 2b is earlier than the timing of turning on the first switching element 2a, and the timing of turning off the first switching element 2a is later than the timing of turning off the second switching element 2b. When the second switching element 2b starts to be turned on, the reference voltage provided by the adjustable voltage source Uref is regulated to the first voltage level. When the first switching element 2a and the second switching element 2b are in a fully turn-on state, the reference voltage provided by the adjustable voltage source Uref is regulated to the second voltage level. When the second switching element 2b starts to be turned off from the fully turn-on state, the reference voltage provided by the adjustable voltage source Uref is regulated to the second voltage level.

From the above descriptions, the present disclosure provides a power circuit and a control method for the power circuit. The inverting input terminal of the comparator in the switch driver chip is electrically connected to an adjustable voltage source to receive a reference voltage from the adjustable voltage source. The voltage value of the reference voltage is regulated to meet the requirement of the current protection response time of the switching elements with different characteristics. Since the switching elements with different switching specifications are protected, the applications of the power circuit will be expanded.

While the disclosure has been described in terms of what is presently considered to be the most practical and preferred embodiments, it is to be understood that the disclosure needs not be limited to the disclosed embodiment. On the contrary, it is intended to cover various modifications and similar arrangements included within the spirit and scope of the appended claims which are to be accorded with the broadest interpretation so as to encompass all such modifications and similar structures.

## Claims

1. A power circuit, comprising:
at least one switching element, wherein each of the at least one switching element comprises a control terminal, a first current conduction terminal and a second current conduction terminal, and the at least one switching element comprises a first switching element;
a switch driver chip configured to control operations of the at least one switching element, and comprising:
a desaturation detection circuit comprising a comparator, wherein a non-inverting input terminal of the comparator is electrically connected to a first current source and the first current conduction terminal of each of the at least one switching element, and an inverting input terminal of the comparator is electrically connected to an adjustable voltage source to receive a reference voltage from the adjustable voltage source; and
a first switch driving circuit electrically connected to an output terminal of the comparator and the control terminal of the first switching element, wherein the first switch driving circuit outputs a first control signal to the control terminal of the first switching element to control the operations of the first switching element according to a comparator output signal from the output terminal of the comparator;
a clamping circuit electrically connected between the non-inverting input terminal of the comparator and the first current conduction terminal of each of the at least one switching element, wherein when one of the at least one switching element is turned on, a voltage at the non-inverting input terminal of the comparator is clamped; and
a capacitor electrically connected between the non-inverting input terminal of the comparator and a ground terminal, wherein the capacitor has a capacitor voltage,
wherein a voltage value of the reference voltage is regulated according to a capacitance value of the capacitor and a switching specification of the at least one switching element, and when the capacitor voltage of the capacitor is greater than the reference voltage, the first switching element is turned off under control of the first switch driving circuit.

2. The power circuit according to claim 1, wherein the reference voltage is generated by an internal circuit of the switch driver chip, or the reference voltage is an external voltage received by a pin of the switch driver chip.

3. The power circuit according to claim 1, wherein the clamping circuit comprises a first resistor and a first diode, wherein a first terminal of the first resistor is electrically connected to the non-inverting input terminal of the comparator, a second terminal of the first resistor is electrically connected to an anode of the first diode, and a cathode of the first diode is electrically connected to the first current conduction terminal of the first switching element.

4. The power circuit according to claim 1, wherein the capacitance value of the capacitor is 1000pF.

5. The power circuit according to claim 1, wherein the power circuit further comprises a second current source electrically connected between the first switch driving circuit and the capacitor, wherein the second current source comprises a second resistor, and the second current source generates a charging current to charge the capacitor.

6. The power circuit according to claim 1, wherein the power circuit further comprises a first voltage protection circuit, and the first voltage protection circuit comprises a second diode, wherein a cathode of the second diode is electrically connected to a voltage source, and an anode of the second diode is electrically connected between the clamping circuit and the non-inverting input terminal of the comparator.

7. The power circuit according to claim 1, wherein the power circuit further comprises a second voltage protection circuit, and the second voltage protection circuit comprises a Zener diode, wherein a cathode of the Zener diode is electrically connected between the clamping circuit and the non-inverting input terminal of the comparator, and an anode of the Zener diode is electrically connected to the ground terminal

8. The power circuit according to claim 1, wherein the at least one switching element further comprises a second switching element, wherein the first switching element and the second switching element are different types of power semiconductor devices.

9. The power circuit according to claim 8, wherein a current protection response time of the first switching element and a current protection response time of the second switching element are different, and the switch driver chip further comprises a second switch driving circuit, wherein the second switch driving circuit is electrically connected to the output terminal of the comparator and the control terminal of the second switching element, and the second switch driving circuit outputs a second control signal to the control terminal of the second switching element to control the operations of the second switching element according to the comparator output signal.

10. The power circuit according to claim 9, wherein in a first operation mode, the first switching element and the second switching element are turned on simultaneously, and the first switching element and the second switching element are turned off simultaneously, wherein when the first switching element and the second switching element start to be turned on, the reference voltage is regulated to a first voltage level corresponding to the current protection response time of the second switching element, wherein when the first switching element and the second switching element are in a fully turn-on state, the reference voltage is regulated to a second voltage level corresponding to the current protection response time of the first switching element, wherein when the first switching element and the second switching element start to be turned off from the fully turn-on state, the reference voltage is regulated to the first voltage level.

11. The power circuit according to claim 9, wherein in a second operation mode, the first switching element and the second switching element are turned on simultaneously, and a timing of turning off the first switching element is later than a timing of turning off the second switching element, wherein when the first switching element and the second switching element start to be turned on, the reference voltage is regulated to a first voltage level, wherein when the first switching element and the second switching element are in a fully turn-on state, the reference voltage provided is regulated to a second voltage level, when the second switching element starts to be turned off from the fully turn-on state, the reference voltage is regulated to the second voltage level.

12. The power circuit according to claim 9, wherein in a third operation mode, a timing of turning on the first switching element is earlier than a timing of turning on the second switching element, and a timing of turning off the first switching element is later than the timing of turning off the second switching element, wherein when the first switching element starts to be turned on, the reference voltage is regulated to a second voltage level, wherein when the first switching element and the second switching element are in a fully turn-on state, the reference voltage is regulated to the second voltage level, wherein when the second switching element starts to be turned off from the fully turn-on state, the reference voltage is regulated to the second voltage level.

13. The power circuit according to claim 9, wherein in a fourth operation mode, a timing of turning on the second switching element is earlier than the timing of turning on the first switching element, and a timing of turning off the first switching element is later than the timing of turning off the second switching element, wherein when the second switching element starts to be turned on, the reference voltage is regulated to a first voltage level, wherein when the first switching element and the second switching element are in a fully turn-on state, the reference voltage is regulated to a second voltage level, wherein when the second switching element starts to be turned off from the fully turn-on state, the reference voltage is regulated to the second voltage level.

14. The power circuit according to claim 9, wherein a source voltage from the voltage source is regulated into two different voltages according to Vgs specifications of the first switching element and the second switching element, and the two different voltages are respectively provided to the first voltage source and the second voltage source.

15. A control method for a power circuit, the power circuit comprising at least one switching element, a switch driver chip, a clamping circuit and a capacitor, each of the at least one switching element comprising a control terminal, a first current conduction terminal and a second current conduction terminal, the at least one switching element comprising a first switching element, the switch driver chip being configured to control operations of the at least one switching element, the switch driver chip comprising a desaturation detection circuit and a first switch driving circuit, the desaturation detection circuit comprising a comparator, a non-inverting input terminal of the comparator being electrically connected to a first current source and the first current conduction terminal of each of the at least one switching element, an inverting input terminal of the comparator being electrically connected to an adjustable voltage source to receive a reference voltage from the adjustable voltage source, the first switch driving circuit being electrically connected to an output terminal of the comparator and the control terminal of the first switching element, the first switch driving circuit outputting a first control signal to the control terminal of the first switching element to control the operations of the first switching element according to a comparator output signal from the output terminal of the comparator, the clamping circuit being electrically connected between the non-inverting input terminal of the comparator and the first current conduction terminal of each of the at least one switching element, a voltage at the non-inverting input terminal of the comparator being clamped when one of the at least one switching element is turned on, the capacitor being electrically connected between the non-inverting input terminal of the comparator and a ground terminal, the capacitor having a capacitor voltage, the control method comprising steps of:
(S1) regulating a voltage value of the reference voltage according to a capacitance value of the capacitor and a switching specification of the first switching element; and
(S2) when the capacitor voltage is greater than the reference voltage, allowing the first switch driving circuit to output the first control signal according to the comparator output signal, and controlling the first switching element to be turned off according to the first control signal.

16. The control method according to claim 15, wherein the at least one switching element further comprises a second switching element, wherein the first switching element and the second switching element are different types of power semiconductor devices, a current protection response time of the first switching element and a current protection response time of the second switching element are different, and the switch driver chip further comprises a second switch driving circuit, wherein the second switch driving circuit is electrically connected to the output terminal of the comparator and the control terminal of the second switching element, and the second switch driving circuit outputs a second control signal to the control terminal of the second switching element to control the operations of the second switching element according to the comparator output signal, wherein in the step (S1), the voltage value of the reference voltage is regulated according to the capacitance value of the capacitor, the switching specification of the first switching element and a switching specification of the second switching element, wherein in the step (S2), when the capacitor voltage is greater than the reference voltage, the second switch driving circuit outputs the second control signal to control the second switching element to be turned off according to the comparator output signal.

17. The control method according to claim 16, wherein when the step (S1) is operated in a first operation mode, the first switching element and the second switching element are turned on simultaneously, and the first switching element and the second switching element are turned off simultaneously, wherein when the first switching element and the second switching element start to be turned on, the reference voltage is regulated to a first voltage level corresponding to the current protection response time of the second switching element, wherein when the first switching element and the second switching element are in a fully turn-on state, the reference voltage is regulated to a second voltage level corresponding to the current protection response time of the first switching element, wherein when the first switching element and the second switching element start to be turned off from the fully turn-on state, the reference voltage is regulated to the first level voltage.

18. The control method according to claim 16, wherein when the step (S1) is operated in a second operation mode, the first switching element and the second switching element are turned on simultaneously, and a timing of turning off the first switching element is later than a timing of turning off the second switching element, wherein when the first switching element and the second switching element start to be turned on, the reference voltage is regulated to a first voltage level, wherein when the first switching element and the second switching element are in a fully turn-on state, the reference voltage provided is regulated to a second voltage level, when the second switching element starts to be turned off from the fully turn-on state, the reference voltage is regulated to the second voltage level.

19. The control method according to claim 16, wherein when the step (S1) is operated in a third operation mode, a timing of turning on the first switching element is earlier than a timing of turning on the second switching element, and a timing of turning off the first switching element is later than the timing of turning off the second switching element, wherein when the first switching element starts to be turned on, the reference voltage is regulated to a second voltage level, wherein when the first switching element and the second switching element are in a fully turn-on state, the reference voltage is regulated to the second voltage level, wherein when the second switching element starts to be turned off from the fully turn-on state, the reference voltage is regulated to the second voltage level.

20. The control method according to claim 16, wherein when the step (S1) is operated in a fourth operation mode, a timing of turning on the second switching element is earlier than the timing of turning on the first switching element, and a timing of turning off the first switching element is later than the timing of turning off the second switching element, wherein when the second switching element starts to be turned on, the reference voltage is regulated to a first voltage level, wherein when the first switching element and the second switching element are in a fully turn-on state, the reference voltage is regulated to a second voltage level, wherein when the second switching element starts to be turned off from the fully turn-on state, the reference voltage is regulated to the second voltage level.
